# EUROPEAN PATENT APPLICATION

(11) **EP 4 851 102 A1**
(43) Date of publication of application: **09.12.2026**
(21) Application number: 26179569.4
(22) Date of filing: 19.05.2026
(51) Int. Cl.: B81B 7/00

(54) **MICROELECTROMECHANICAL SENSOR HAVING A CONDENSATION PROTECTION STRUCTURE**

(30) Priority: 04.06.2025 IT 202500012934
(71) Applicant: STMicroelectronics International N.V., 1228 Plan-les-Ouates, Geneva (CH)
(72) Inventor: CARMINATI, Roberto, 20864 AGRATE BRIANZA (MB) (IT); DANIELE, Filippo, 20864 AGRATE BRIANZA (MB) (IT); BALDO, Lorenzo, 20864 AGRATE BRIANZA (MB) (IT); NICOLI, Silvia, 20864 AGRATE BRIANZA (MB) (IT)
(74) Representative: Studio Torta S.p.A.

(57) **Abstract**

A microelectromechanical sensor (10) is described, that has: a substrate (12); at least one sensing element (13') provided at the substrate (12); a cap layer (15), bonded to the substrate (12) to cover the sensing element (13'), at least one access opening (18) being formed through the cap layer (15), to put the sensing element (13') in communication with an external environment. A condensation protection structure (25) is provided in the cap layer (15), to determine, by capillary effect, the collection therewithin of condensation liquid deriving from gases coming from the external environment through said access opening (18).

## Description

### TECHNICAL FIELD

The present solution relates to a microelectromechanical sensor having a condensation protection structure.

### BACKGROUND

As is known, current micromanufacturing technologies allow providing microelectromechanical systems (so-called MEMS, Micro Electro Mechanical System) starting from substrates of semiconductor material, in particular silicon.

Sensors made using these technologies are widely used, for example in the "automotive" field, for inertial navigation, or in the field of portable or wearable electronic devices for consumer electronics, such as smartphones, tablets, smartwatches, smartbands, smartglasses or similar.

In particular, environmental sensors made using the MEMS technology and semiconductor materials (hereinafter simply referred to as MEMS environmental sensors) are known, having, in a corresponding package, one or more openings, ports or vents, in communication with the external environment.

In general, a MEMS environmental sensor, such as a pressure sensor (or barometric sensor) or a gas or other environmental parameter sensor, comprises a functional substrate, wherein at least one sensing or detection element is provided (for example for sensing a pressure or a gaseous species) and a cap, suitably bonded to the functional substrate, to protect the sensing element. At least one access opening is formed through the cap, so as to put the sensing element provided in the functional substrate in fluidic communication with the external environment (and the pressure or other environmental parameter that needs to be sensed).

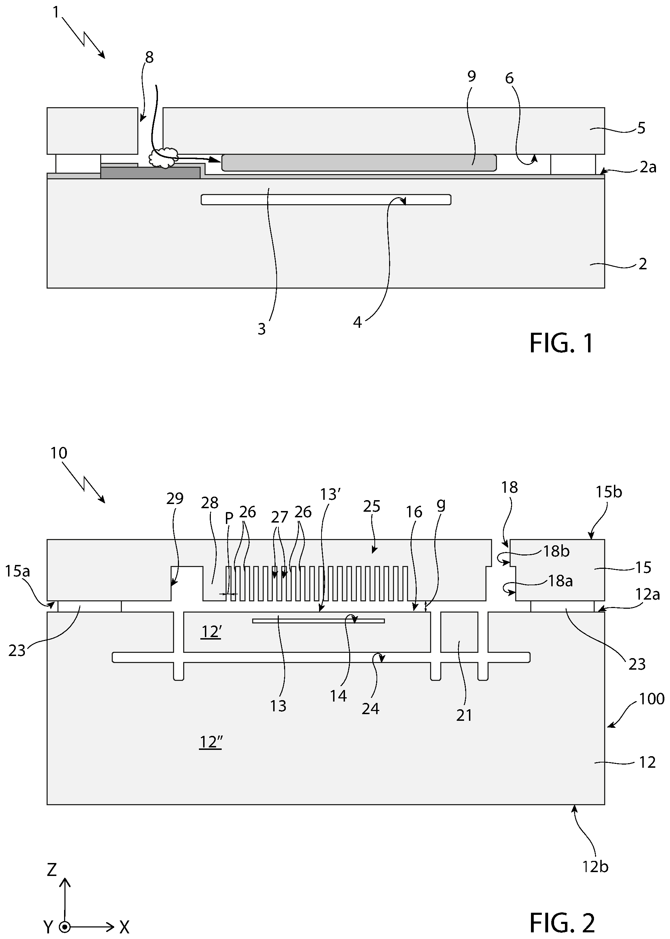

By way of example, Figure 1 shows a MEMS sensor of a known type, defining an environmental sensor, in particular a pressure sensor, denoted by 1.

The MEMS sensor 1 comprises a functional substrate 2 having a front surface 2a at which a membrane 3 is formed, arranged suspended above a cavity 4, buried in a surface portion of the same functional substrate 2.

The pressure sensor 1 has a substrate-level (or wafer-level) package and comprises a cap layer 5, also of semiconductor material, for example silicon, bonded by bonding techniques on the front surface 2a of the functional substrate 2, at a certain separation distance, or gap; in particular, this gap defines a chamber 6 above the membrane 3.

At least one access opening 8 is formed through the entire thickness of the cap layer 5, so as to put the chamber 6, and consequently the membrane 3, in communication with the external environment.

During operation, the membrane 3 undergoes a deformation as a function of the pressure of the external environment; in a manner not illustrated, sensing elements, for example piezoresistors (in the case of a piezoresistive-type pressure sensor), may be provided in the membrane 3, to allow sensing the deformation and, consequently, the value of the pressure to be sensed. Alternatively, in the case of a capacitive-type pressure sensor, the same membrane 3 may define a first electrode of a sensing capacitor, the capacitance of which varies as a function of the pressure to be sensed.

A problem that affects MEMS environmental sensors, as shown schematically in the aforementioned Figure 1, is due to the fact that the access opening 8 also allows unwanted gases that may be generated during the manufacturing or final assembly process (for example, gases resulting from processes of soldering the same package to a printed circuit board) to enter inside the package.

These gases may subsequently condense inside the package, in particular inside the aforementioned chamber 6, leading to the formation of liquid (schematically indicated by 9), also due to the small spaces that favor condensation (by capillary effect).

Such liquid 9, if remaining on the membrane 3 (or, in general, on sensing elements of the MEMS environmental sensor 1 or in any case on critical elements for the operation and sensing operations of the same MEMS environmental sensor 1), may cause errors in the sensing signals provided (with a consequent lower precision or sensing accuracy) or, in the worst case, even failures or catastrophic effects (short circuits or uncontrolled drifts of the output).

Some solutions that have been proposed to try limiting such condensation problem envisage forming the access opening(s) through the cap at a sufficiently high distance from the sensing (or critical) element of the MEMS environmental sensor.

Other solutions envisage providing different types of packages, not being substrate-level (or wafer-level) packages, with a cap made of plastic (or ceramic) materials having a hollow or cup shape, such as to ensure a large gap between the membrane and an internal upper surface of the same cap.

However, both solutions entail rather large resulting dimensions of the package of the MEMS environmental sensor and in general do not allow to completely avoid the discussed issues related to the condensation of gases and the resulting formation of liquids at the sensing or critical elements of the same MEMS environmental sensor.

### Summary

The present solution generally aims to overcome the limitations of MEMS sensors of a known type, at least one access opening towards the external environment, and to provide an answer to the aforementioned condensation issue at the sensing or critical elements of the same MEMS sensors.

According to the present solution, a microelectromechanical sensor and a corresponding manufacturing process are provided, as defined in the attached claims.

### BRIEF DESCRIPTION OF THE FIGURES

For a better understanding of the present invention, a preferred embodiment is now described, purely by way of nonlimiting example and with reference to the attached drawings, wherein:
- Figure 1 shows a schematic cross-section of a MEMS sensor, of a known type;
- Figure 2 shows a schematic cross-section of a MEMS sensor, according to an embodiment of the present solution;
- Figure 3 shows the schematic cross-section of the MEMS sensor, in an operating configuration, in the presence of gas condensation and liquid formation at a condensation protection structure;
- Figure 4 is a schematic plan view of the MEMS sensor, in a possible implementation; and
- Figures 5A-5C show schematic plan views of possible embodiments of the condensation protection structure.

### DESCRIPTION OF THE EMBODIMENTS

As will be described in detail below, one aspect of the present solution envisages providing a condensation protection structure, integrated into the cap substrate of a MEMS sensor, in particular of an environmental type sensor, i.e. having one or more access openings towards an external environment formed through the same cap substrate.

This condensation protection structure is configured to determine, by capillary effect, the collection of condensation liquid deriving from unwanted gases coming from the external environment through the aforementioned access openings; and in particular to cause, by capillarity, the condensation of the gases that have entered the sensor and/or to attract, due to capillary force, any condensation liquids formed inside the sensor due to the entry of such gases.

Figure 2 shows a MEMS sensor, in particular a MEMS environmental sensor 10, that comprises in a corresponding cap substrate, as will be described in detail below, a condensation protection structure.

By way of example, the MEMS environmental sensor 10 is also in this case a pressure sensor or barometric sensor, that comprises, in analogy to what has been previously discussed, a functional substrate, here indicated by 12, having a front surface 12a and a rear surface 12b, both the front and rear surfaces 12a, 12b having extension in a horizontal plane xy and being opposed to each other along a vertical axis z, orthogonal to the horizontal plane xy.

The MEMS environmental sensor 10 comprises at least one sensing element 13', in the example formed by a membrane 13, arranged at the front surface 12a of the functional substrate 12, suspended above a cavity 14, buried inside the same functional substrate 12.

In particular, in the example illustrated, the cavity 14 and the overlying membrane 13 are formed in a surface portion 12' of the functional substrate 12, that is arranged suspended in a cantilever manner with respect to a body portion 12" of the same functional substrate 12, to which the surface portion 12' is elastically coupled through at least one supporting elastic element 21. The surface portion 12' is therefore separated (and decoupled) from the body portion 12" of the functional substrate 12 by a separation space 24.

In a manner not illustrated, piezoresistive elements for sensing the deformation of the membrane 13 due to the pressure acting in the external environment may be provided inside the membrane 13; alternatively, the same membrane 13 may define an electrode of a sensing capacitor, whose capacity varies as a function of the external pressure.

The MEMS environmental sensor 10 also comprises a cap layer 15, preferably also made of semiconductor material, for example silicon, coupled above the front surface 12a of the functional substrate 12, to form a substrate-level (or wafer-level) package, generally indicated by 100, for the same MEMS environmental sensor 10.

In particular, the cap layer 15 has a lower surface 15a, facing the front surface 12a of the functional substrate 12 and separated from the latter by a separation space, or gap, indicated by g, that defines a chamber 16 above the same membrane 13. This gap g has a small value (for example much smaller than a thickness of the cap layer 15 along the vertical axis z), typically of the order of a few µm, for example comprised between 5 and 10 µm.

The cap layer 15 is bonded to the functional substrate 12 by bonding regions 23, that define, with their dimension along the vertical axis z, the gap g between the front surface 12a of the functional substrate 12 and the lower (or facing) surface 15a of the cap layer 15.

At least one access opening 18 is formed through the entire thickness of the cap layer 15, in such a way as to put the aforementioned chamber 16 (and the sensing element 13', in the example the membrane 13) in communication with the external environment and allow, for example, entry of pressure waves from the same external environment towards the inside of the package 100.

In the embodiment illustrated by way of example in Figure 2, the aforementioned access opening 18 is provided by two opening portions in fluidic communication with each other and that jointly form the same access opening 18: a first opening portion 18a, at the lower surface 15a of the cap layer 15, having a first height along the vertical axis z and a first width along a horizontal axis x of the aforementioned horizontal plane xy; and a second opening portion 18b, at an upper surface 15b of the cap layer 15 (opposite along the vertical axis z with respect to the aforementioned lower surface 15a), having a second thickness along the vertical axis z, in the example lower than the first opening portion 18a, and a second width along the horizontal axis x, in the example also lower than the first opening portion 18a.

According to a particular aspect of the present solution, the MEMS environmental sensor 10 also comprises a condensation protection structure, indicated by 25, provided in the cap layer 15.

In the embodiment illustrated in Figure 2, this condensation protection structure 25 is provided in proximity to or at the sensing element 13', in particular above the same sensing element 13' (with respect to the vertical axis z).

Such condensation protection structure 25 is formed starting from the lower surface 15a of the cap layer 15 and extends inside the same cap layer 15 along the vertical axis z, towards the corresponding upper surface 15b (without however reaching such upper surface 15b).

The condensation protection structure 25 is configured to cause gas condensation and liquid formation therewithin, exploiting the condensation effect by capillarity. Furthermore, in case liquids are formed by condensation inside the package 100 of the MEMS environmental sensor 10, the same condensation protection structure 25 is configured, again due to capillary force, to attract such liquids.

The condensation structure 25 thereby prevents liquids from being able to form and/or remain at the sensing element 13' of the MEMS environmental sensor 10 (and/or at other sensing elements or in general at critical elements of the same MEMS environmental sensor 10).

In detail, the condensation protection structure 25 comprises a plurality of structural elements 26, having a high aspect ratio, i.e. a high ratio between a corresponding larger dimension and a corresponding smaller dimension (for example, such aspect ratio may be about, or greater than, ten) .

In the illustrated embodiment, the structural elements 26 have a height extension (along the vertical axis z) greater, typically much greater, than a corresponding width extension (along the first horizontal axis x of the horizontal plane xy). For example, the aforementioned width of the structural elements 26 is comprised between 1 µm and 5 µm, for example it is equal to 1 µm, and their height is comprised between a few tens of µm up to about a hundred µm (such height being for example around approximately half of an overall thickness of the cap layer 15 along the vertical axis z).

For example, the aforementioned structural elements 26 may have a columnar or pillar shape.

The same structural elements 26 are mutually organized in a repeated arrangement (for example in a grid, lattice or matrix), arranged at a short separation distance from each other or pitch, indicated by p in Figure 2 (in the example, referred to the first horizontal axis x). This pitch p is typically much smaller than the largest dimension of the structural elements 26 and comparable (having the same order of magnitude) with the smaller dimension of the same structural elements 26.

In particular, such pitch p is preferably smaller than the separation gap g between the front surface 12a of the functional substrate 12 and the lower surface 15a of the cap layer 15, in such a way as to boost the described capillarity effect; the pitch p may for example be comprised in a range from 1 µm to 5 µm.

Structural elements 26 that are adjacent (for example, but not limited to, with respect to the first horizontal axis x) define therebetween spaces or interstices 27 for liquid collection, having a small width and a large height, of which the same adjacent structural elements 26 define the side walls.

As shown in the aforementioned Figure 2, a stopper 28 may also be formed in the cap layer 15, laterally and in proximity to the condensation protection structure 25, configured to stop possible deformation of the membrane 23 along the vertical axis z, without such deformation causing damage to the condensation protection structure 25.

Such stopper 28 is interposed in the example between a last structural element 26 of the condensation protection structure 25, on one side, and a recess 29 formed starting from the lower surface 15a of the cap layer 15, on the other side (along the horizontal axis x).

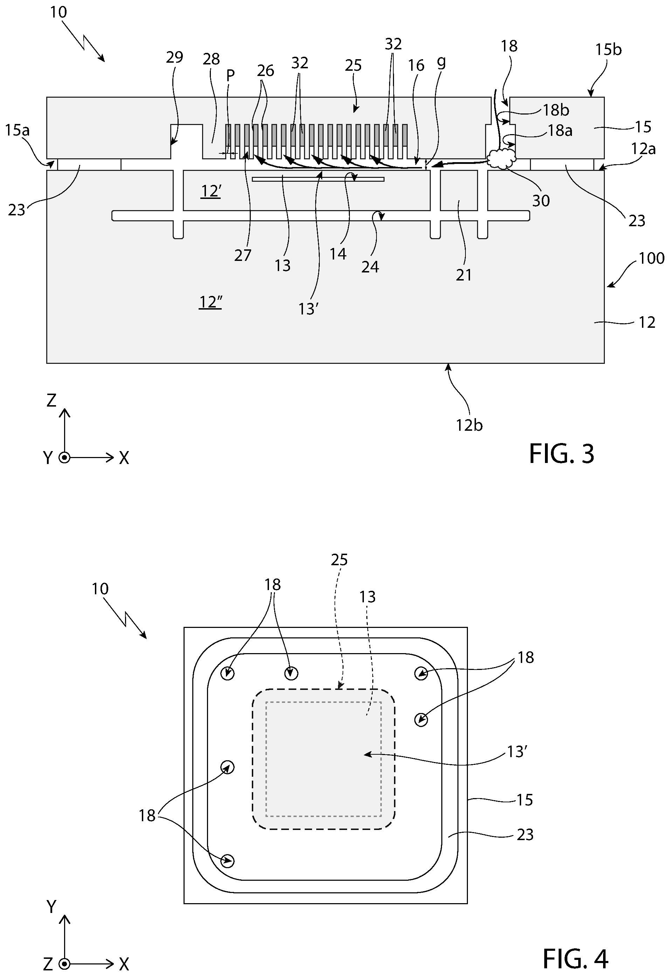

During operation, as illustrated in Figure 3, gases, indicated by 30, that may enter inside the package 100 of the MEMS environmental sensor 10 through the access opening 18 (for example unwanted gases that may be generated during the manufacturing process or the final assembly process), are forced to condense by capillary effect in the condensation protection structure 25, within the spaces or interstices 27 formed between the corresponding structural elements 26, inside which a corresponding condensation liquid, indicated here by 32, forms and remains.

Given also the high aspect ratio of such spaces or interstices 27, the same condensation liquid 32 once formed does not flow outside the same condensation protection structure 25.

As previously indicated, even in case the gases 30 condense elsewhere inside the package 100 of the MEMS environmental sensor 10, the resulting condensation liquid is attracted inside the condensation protection structure 25 by the capillary force, in particular freeing the sensing element 13' (or, in general, further sensing or, in any case, critical elements in the MEMS environmental sensor 10).

Figure 4 shows in plan view a possible configuration of the MEMS environmental sensor 10, wherein the condensation protection structure 25 has an extension area (in the horizontal plane xy) substantially corresponding to the extension of the membrane 13 (or sensing element 13') of the same MEMS environmental sensor 10; in particular, in the example, this extension is substantially square-shaped in the horizontal plane xy.

In the same example, the aforementioned bonding regions 23, that define the separation gap g between the front surface 12a of the functional substrate 12 and the lower surface 15a of the cap layer 15, are arranged to form a substantially square ring around the aforementioned extension area of the condensation protection structure 25.

In the example shown in such Figure 4, the MEMS environmental sensor 10 comprises by way of example a certain number of access openings 18, arranged in plan view laterally to the aforementioned membrane 13, interposed between the same membrane 13 and the bonding regions 23. The presence of a certain number (in this case greater than one) of access openings 18 may be advantageous for functional redundancy, for example in case one or more of such access openings 18 may become obstructed in whole or in part over time.

The aforementioned structural elements 26 of the condensation protection structure 25 may generally have various shapes.

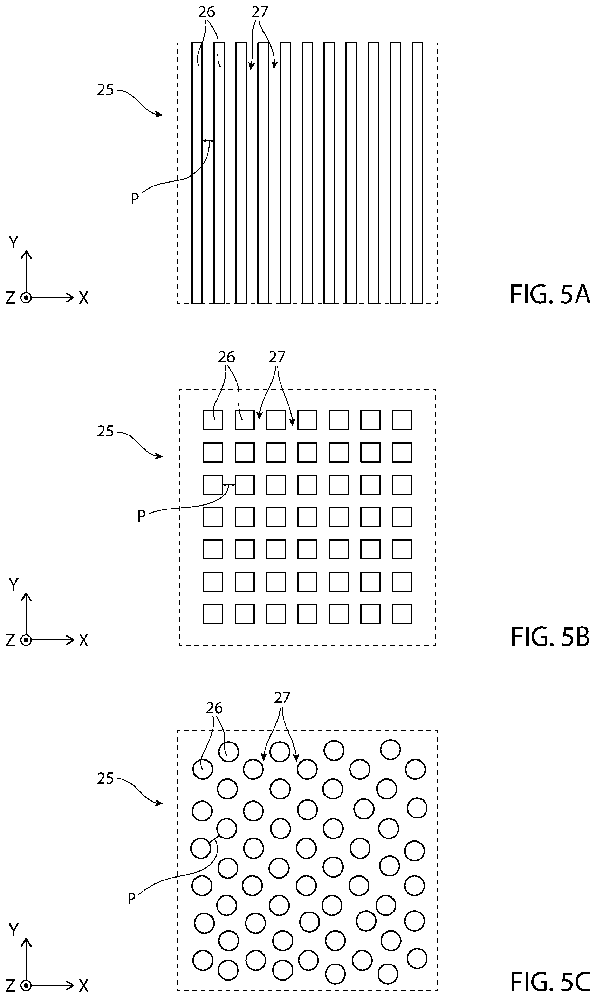

For example, as shown schematically in Figure 5A, the structural elements 26 may be elongated along a second horizontal axis y of the horizontal plane xy (arranged in a mutually parallel position, at the separation distance defined by the pitch p; or, as shown in Figure 5B, the structural elements 26 may have a columnar shape, with a substantially square section in the horizontal plane xy and being organized in a regular grid or lattice; or again, as shown in Figure 5C, the same structural elements 26 may have a substantially circular section in the horizontal plane xy and be organized in a sort of honeycomb lattice.

In general, the shape and mutual arrangement of the aforementioned structural elements 26 of the condensation protection structure 25 may differ from the illustrated examples, provided that their arrangement allows to obtain, as previously discussed, the condensation of the gas therewithin by capillarity.

For example, in a further embodiment, the aforementioned condensation protection structure 25 might have an extension area arranged in the horizontal plane xy around the sensing element 13' of the MEMS environmental sensor 10 (in the example, externally and surrounding the membrane 13, for example with a ring or frame shape interposed between the same membrane 13 and the bonding regions 23).

The aforementioned condensation protection structure 25 may advantageously be formed during the manufacturing process of the MEMS environmental sensor 10, by suitable patterning of the cap layer 15, with an etching performed starting from the corresponding lower surface 15a.

In particular, the structural elements 26 may be patterned by etching performed starting from the lower surface 15a, through a suitable etching mask.

Advantageously, such etching may be provided with the same etching step that leads to the formation of the aforementioned first opening portion 18a of the access opening 18, formed at the lower surface 15a of the cap layer 15. Consequently, the height of the structural elements 26 may correspond in this case to the aforementioned first thickness of the first opening portion 18a along the vertical axis z.

The advantages of the proposed solution are clear from the preceding description.

In any case, it is emphasized again that the described condensation protection structure 25, integrated in the cap layer 15 of the MEMS environmental sensor 10, allows to effectively collect therewithin (by capillarity) the condensation liquids that are formed due to unwanted gases that have entered the package 100 through the access opening 18. In this manner, the same condensation liquids do not go towards and do not stay at the sensing (or in any case critical) elements of the same MEMS environmental sensor 10.

In other words, the condensation protection structure 25 defines an area where the gases are forced to condense due to capillary forces and where the resulting condensation liquids collect, without the same condensation liquids being able to cause problems, errors or failures.

Finally, it is clear that modifications and variations may be made to what has been described and illustrated herein without thereby departing from the scope of the present invention, as defined in the attached claims.

In particular, it is again underlined that the actual dimensions and shape of the condensation protection structure 25 and the corresponding structural elements 26 may differ from what has been described by way of example, provided that they allow the desired condensation effect by capillarity.

Furthermore, the condensation protection structure described may find advantageous application for any type of microelectromechanical (MEMS) sensor, that has one or more openings in fluidic communication towards an external environment, through which unwanted gases may be introduced, for example during a corresponding manufacturing and/or final assembly process.

## Claims

1. A microelectromechanical sensor (10), comprising:
a substrate (12);
at least one sensing element (13') formed at said substrate (12);
a cap layer (15), bonded to said substrate (12) to cover said sensing element (13'), at least one access opening (18) being formed through the cap layer (15), to put said sensing element (13') in communication with an external environment,
**characterized by** further comprising a condensation protection structure (25), integrated in said cap layer (15), configured to determine, by capillary effect, the collection therewithin of condensation liquid deriving from gases coming from the external environment through said access opening (18).

2. The sensor according to claim 1, wherein said condensation protection structure (25) is configured to cause condensation therewithin of the gases coming from the external environment through said access opening (18) and/or to attract, by capillary force, condensation liquids formed inside the microelectromechanical sensor (10) due to the entry of gases through said access opening (18).

3. The sensor according to claim 1 or 2, wherein said condensation protection structure (25) is formed by a plurality of structural elements (26), mutually organised in a repeated arrangement, arranged from each other at a separation distance or pitch (p).

4. The sensor according to claim 3, wherein said substrate (12) has a front surface (12a) and a rear surface (12b), having an extension in a horizontal plane (xy) and being opposite to each other along a vertical axis (z) orthogonal to the horizontal plane (xy); and wherein said structural elements (26) have a larger dimension in the direction of said vertical axis (z) and a corresponding smaller dimension in said horizontal plane (xy) and said pitch (p) is smaller than the larger dimension and comparable with the smaller dimension of said structural elements (26).

5. The sensor according to claim 3 or 4, wherein said cap layer (15) has a lower surface (15a), facing the front surface (12a) of the substrate (12) and separated from said front surface (12a) by a separation gap (g); said pitch (p) being smaller than said separation gap (g).

6. The sensor according to claim 5, wherein said structural elements (26) have a height extension, starting from said lower surface (15a) of said cap layer (15), along said vertical axis (z) greater than a corresponding width extension, along a first horizontal axis (x) of said horizontal plane (xy); adjacent structural elements (26) defining spaces or interstices (27) for liquid collection therebetween, having a high aspect ratio, with a small width and a high height, of which said adjacent structural elements (26) define side walls.

7. The sensor according to claim 6, wherein said access opening (18) is formed by two opening portions in fluidic communication with each other and that jointly form said access opening (18): a first opening portion (18a), at the lower surface (15a) of the cap layer (15), having a first height along said vertical axis (z) and a first width along said horizontal axis (x); and a second opening portion (18b), at an upper surface (15b) of the cap layer (15), having a second thickness along said vertical axis (z) and a second width along said horizontal axis (x); wherein said height extension of said structural elements (26) is equivalent to the thickness of said first opening portion (18a).

8. The sensor according to anyone of claims 5-7, wherein said cap layer (15) is bonded to the substrate (12) by bonding regions (23), that define, with a dimension thereof along the vertical axis (z), said separation gap (g) between the front surface (12a) of the substrate (12) and the lower surface (15a) of the cap layer (15); and wherein said separation gap (g) defines a chamber (16) above said sensing element (13').

9. The sensor according to anyone of claims 3-8, wherein said sensing element (13') is formed by a membrane (13), arranged at the front surface (12a) of the substrate (12), suspended above a cavity (14), buried inside a surface portion of said substrate (12); wherein said membrane (13) is designed to deform as a function of pressure waves coming from the external environment through said access opening (18).

10. The sensor according to anyone of the preceding claims, wherein said condensation protection structure (25) is arranged at said sensing element (13') formed in said substrate (12).

11. The sensor according to anyone of the preceding claims, wherein said condensation protection structure (25) is arranged above said sensing element (13') formed in said substrate (12).

12. The sensor according to anyone of the preceding claims, being of environmental type.

13. A process for manufacturing a microelectromechanical sensor (10), comprising:
providing a substrate (12);
forming at least one sensing element (13') at said substrate (12);
coupling a cap layer (15) to said substrate (12) to cover said sensing element (13');
forming at least one access opening (18) through the cap layer (15), to put said sensing element (13') in communication with an external environment,
**characterised by** further comprising forming a condensation protection structure (25) integrated in said cap layer (15), configured to determine, by capillary effect, the collection therewithin of condensation liquid starting from gases coming from the external environment through said access opening (18).

14. The process according to claim 13, wherein forming said condensation protection structure (25) comprises performing an etching of said cap layer (15) starting from a lower surface (15a), designed to face a corresponding surface (12a) of said substrate (12).

15. The process according to claim 14, wherein forming said access opening (18) comprises forming two opening portions in fluidic communication with each other and that jointly form said access opening (18): a first opening portion (18a), at the lower surface (15a) of the cap layer (15); and a second opening portion (18b), at an upper surface (15b) of the cap layer (15), opposite to said lower surface (15a) along a vertical axis (z); wherein said etching of said cap layer (15) for the formation of the condensation protection structure (25) is performed jointly with the etching that leads to the formation of said first opening portion (18a) of the access opening (18).
